# EUROPEAN PATENT SPECIFICATION

(11) **EP 3 349 254 B1**
(45) Date of publication and mention of the grant of the patent: **02.06.2021**
(21) Application number: 18150982.9
(22) Date of filing: 10.01.2018
(51) Int. Cl.: H01L 31/05, H02S 30/20, H02S 40/38, H01L 31/0304, H01L 31/0392

(54) **SOLAR CELL MODULE**
SOLARZELLENMODUL
MODULE DE CELLULE SOLAIRE

(30) Priority: 11.01.2017 KR 20170004344
(43) Date of publication of application: 18.07.2018
(73) Proprietor: LG Electronics Inc., Seoul 07336 (KR)
(72) Inventor: CHEUN, Hyeunseok, Seoul 06772 (KR); KIM, Jeongshik, Seoul 06772 (KR); SHIN, Junoh, Seoul 06772 (KR); LEE, Jeongsoo, Seoul 06772 (KR)
(74) Representative: Katérle, Axel

(56) References cited:
- EP-A1- 2 731 147
- US-A1- 2005 268 959
- US-A1- 2011 073 165
- US-A1- 2015 368 833

## Description

### BACKGROUND OF THE INVENTION

### 1. Field of the Invention

This specification relates to a solar cell module having a flexibility so as to be bendable, and a portable charger having the same.

### 2. Background of the Invention

A solar cell is formed to convert light energy into electric energy. Generally, the solar cell is composed of a P-type semiconductor and an N-type semiconductor, and generates a potential difference as charges move when illuminated by light.

A solar cell module indicates a module provided with a solar cell and configured to generate a power from light. A module means a constituent unit of a machine, a system, etc., and indicates an independent apparatus formed as a plurality of electronic components or mechanical components are assembled with each other and having a specific function. Thus, the solar cell module may be understood as an independent apparatus provided with a solar cell and having a function to generate a power from light.

An electricity generation capacity of the solar cell module is variable according to a light receiving area. Thus, for a sufficient electricity generation capacity, the light receiving area should be sufficiently obtained. In this case, a device provided with the solar cell module may be increased due to the increase of the light receiving area.

On the other hand, a portable device should be minimized for enhanced portability, because it is inconvenient to carry the portable device if the portable device has a large size.

It is difficult to obtain a light receiving area and to minimize the portable device, simultaneously. The portable device provided with the solar cell module, such as a portable charger, should obtain a light receiving area and have a minimized size.

If the solar cell module is bendable, a user may carry the solar cell module in a folded or rolled manner, and may use the solar cell module in an unfolded manner at the time of generating electricity. Thus, if the solar cell module is bendable, a light receiving area (or a light collecting area) can be obtained and the portable device can be minimized.

However, since the solar cell module is provided with a plurality of solar cells
connected to each other in series, a flexible structure to electrically connect the solar cells to each other should be considered for bending of the solar cell module.

US 2015/368833 A1 discloses that an epitaxially grown layer III-V solar cell is separated from the growth substrate. A sacrificial epitaxial layer is embedded between the GaAs wafer and the solar cell. The sacrificial layer is damaged by absorbing IR laser radiation. A laser is chosen with the right wavelength, pulse width and power. The radiation is not absorbed by either the GaAs wafer or the solar cell. The solar cell is detached from the growth wafer by propagating a crack through the damaged layer. Several cells are integrated on a common blanket polyimide sheet and interconnected by copper plating. The blanket is covered with a transparent spray-on polyimide that replaces the cover glass. The solar cell is stress-balanced to remain flat on orbit.

EP 2 731 147 A1 discloses a solar module including a plurality of solar cells each having a photoelectric conversion unit and first and second electrodes, as well as a wiring member and an adhesive layer. Between adjacent solar cells, the wiring member electrically connects the first electrode of one solar cell to the second electrode of the other solar cell. The wiring member has an insulating substrate and wiring. The first and second electrodes each have a plurality of finger portions. The wiring has an adherend portion bonded to the solar cells by means of an adhesive layer. The adherend portion is provided over the finger portions and over the section of the photoelectric conversion unit in which the finger portions are not provided.

### SUMMARY OF THE INVENTION

In view of the above, an aspect of the detailed description is to provide a solar cell module having a flexibility so as to be bendable, and a portable device having the same capable of obtaining a light receiving area for a sufficient electricity generation capacity, and capable of having a minimized size.

Another aspect of the detailed description is to provide an interconnector capable of electrically connecting two neighboring solar cells to each other, and maintaining a mechanical strength and a reliability even when a solar cell module is bent, and a solar cell module having the interconnector.

Another aspect of the detailed description is to provide an interconnector capable of preventing a short circuit, and a solar cell module having the interconnector.

To achieve these and other advantages and in accordance with the purpose of this specification, as embodied and broadly described herein, there are provided
two solar cells disposed to be adjacent to each other, and an interconnector. The two solar cells include III-V group compound semiconductors. The interconnector is electrically connected to a lower electrode of one of the two solar cells and an upper electrode of another of the two solar cells.

If it is assumed that one of the two solar cells is a first solar cell and another of the two solar cells is a second solar cell, the interconnector is disposed between the first and second solar cells so as to serially connect the first and second solar cells to each other.

Each of the first and second solar cells includes: a flexible substrate; a lower electrode formed on the flexible substrate; a III-V group compound semiconductor partially formed on the lower electrode such that a partial region of the lower electrode is exposed to outside; and an upper electrode formed on the III-V group compound semiconductor.

The interconnector is disposed to cover a space between the first and second solar cells, and is electrically connected to the lower electrode of the first solar cell and the upper electrode of the second solar cell.

The interconnector includes: a base having a non-conductivity and an elasticity; a conductive layer formed on one surface of the base, and electrically connected to the lower electrode of the first solar cell and the upper electrode of the second solar cell; and an insulating layer formed on one surface of the conductive layer, and configured to prevent a short circuit between the lower electrode of the second solar cell and the upper electrode of the second solar cell.

The conductive layer may be formed as a conductive coating layer formed by coating a conductive material on the base.

The insulating layer may be formed as an insulating coating layer formed by coating an insulating tape on the conductive layer. The insulating layer may be formed as an insulating adhesive layer formed by attaching an insulating tape onto the conductive layer. The insulating layer may be formed as a dielectric deposition layer formed by depositing a dielectric material between the two neighboring solar cells.

The base may have a thickness of 10∼200 *µ*m, and the conductive coating layer may have a thickness of 1-100 *µ*m.

The conductive layer is protruded towards both sides of the insulating layer. One side of the conductive layer contacts the lower electrode of the first solar cell, and another side thereof contacts the upper electrode of the second solar cell.

A boundary may be formed between the first and second solar cells for bending of the solar cell module. The interconnector may include: an extended part extended along the boundary; a first protruded part protruded from one end of the extended part to both sides, towards the lower electrode of the first solar cell and the upper electrode of the second solar cell; and a second protruded part protruded from another end of the extended part to both sides, towards the lower electrode of the first solar cell and the upper electrode of the second solar cell.

The conductive layer may be formed at the first and second protruded parts, and the insulating layer may be formed at the extended part.

One side of the first protruded part and one side of the second protruded part may contact the lower electrode of the first solar cell, and another side of the first protruded part and another side of the second protruded part may contact the upper electrode of the second solar cell.

One or more holes may be formed at the extended part. The hole may be provided in plurality, and the holes may be spaced apart from each other.

The solar cell module may further comprises a passivation film configured to cover the solar cells and the interconnector.

The flexible substrate may have a thickness of 50∼1,000 *µ*m.

Each of the upper and lower electrodes may be formed to have a thickness of 1∼15 *µ*m. The III-V group compound semiconductor may have a thickness of 1∼4 *µ*m.

To achieve these and other advantages and in accordance with the purpose of this specification, as embodied and broadly described herein, there is also provided a portable charger having the solar cell module, comprising: a housing; a scroll bar installed in the housing; a solar cell module withdrawn from the housing by being unwound from the scroll bar, and inserted into the housing by being wound on the scroll bar; a battery installed in the housing, and configured to store therein a power generated from the solar cell module; and a terminal exposed to outside of the housing so as to be connectable with an external device, and configured to transmit the power provided from the battery to the external device, wherein the solar cell module includes: a first solar cell and a second solar cell disposed to be adjacent to each other; and an interconnector disposed between the first and second solar cells, and configured to serially connect the first and second solar cells with each other, wherein each of the first and second solar cells includes: a flexible substrate; a lower electrode formed on the flexible substrate; a III-V group compound semiconductor partially formed on the lower electrode such that a partial region of the lower electrode is exposed to outside; and an upper electrode formed on the III-V group compound semiconductor, and wherein the interconnector is disposed to cover a space between the first and second solar cells, and is electrically connected to the lower electrode of the first solar cell and the upper electrode of the second solar cell.

The solar cell module may include strings connected to each other in parallel, each of the strings may include solar cells connected to each other in series, and each of the solar cells may be connected and bonded to its neighboring solar cell by the interconnector.

The solar cell module may further include a cover film which covers both surfaces of the solar cells. And the cover film may be formed of a polyethylene terephthalate (PET) material, a thermoplastic resin may be adhered to an outer surface of the PET material, and the cover film may be thermally encapsulated on said both surfaces of the solar cells.

Further scope of applicability of the present application will become more apparent from the detailed description given hereinafter.

### BRIEF DESCRIPTION OF THE DRAWINGS

The accompanying drawings, which are included to provide a further understanding of the invention and are incorporated in and constitute a part of this specification, illustrate exemplary embodiments and together with the description serve to explain the principles of the invention.

In the drawings:
FIG. 1 is a conceptual view of a portable charger according to the present invention;
FIG. 2 is a planar view of a solar cell module provided at a portable charger;
FIG. 3 is a sectional view taken along line 'A-A' in the solar cell module of FIG. 2, which is viewed from one side;
FIG. 4 is a sectional view taken along line 'B-B' in the solar cell module of FIG. 2, which is viewed from one side;
FIG. 5 is a planar view of an interconnector; and
FIG. 6 is a bottom view of the interconnector.

### DETAILED DESCRIPTION OF THE INVENTION

Hereinafter, a solar cell module and a portable charger having the same according to the present invention will be explained in more detail with reference to the attached drawings. For the sake of brief description with reference to the drawings, the same or equivalent components will be provided with the same reference numbers, and description thereof will not be repeated. A singular expression includes a plural concept unless there is a contextually distinctive difference therebetween.

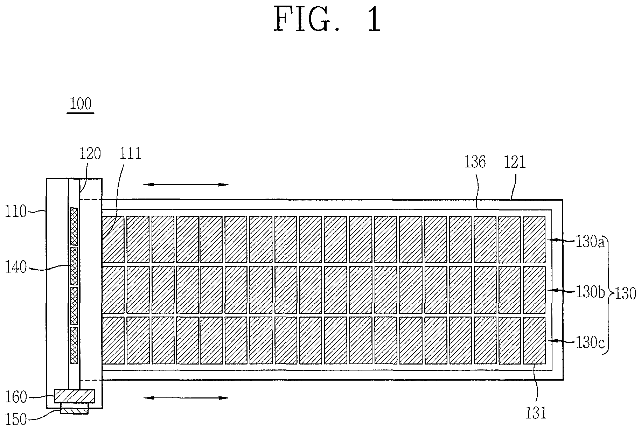

FIG. 1 is a conceptual view of a portable charger 100 according to the present invention.

The portable charger 100 should be formed to have a portable size, and should have a large light receiving area in order to sufficiently generate a power by using a solar cell module 130. The portable charger 100 of the present invention includes the solar cell module 130 withdrawn from or introduced into the housing 110.

The housing 110 forms an appearance of the portable charger 100. A space for accommodating the solar cell module 130 therein is formed in the housing 110. The components of the portable charger 100 are installed in the housing 110, and some of the components may be exposed to the outside of the housing 110.

A scroll bar 120 is rotatably installed in the housing 110. A screen 121 is connected to the scroll bar 120. When the scroll bar 120 is rotated, the screen 121 wound on the scroll bar 120 is unwound from the scroll bar 120 to thus be withdrawn from the housing 110. If the scroll bar 120 is rotated in the opposite direction, the screen 121 is wound on the scroll bar 120 to thus be introduced into the housing 110.

The solar cell module 130 is arranged on at least one surface of the screen 121, and is withdrawn from or introduced into the housing 110 along the screen 121. A hole 111 may be formed at the housing 110 for introduction and withdrawal of the screen 121 and the solar cell module 130 into/from the housing 110. And the screen 121 and the solar cell module 130 are withdrawn from the housing 110 through the hole 111.

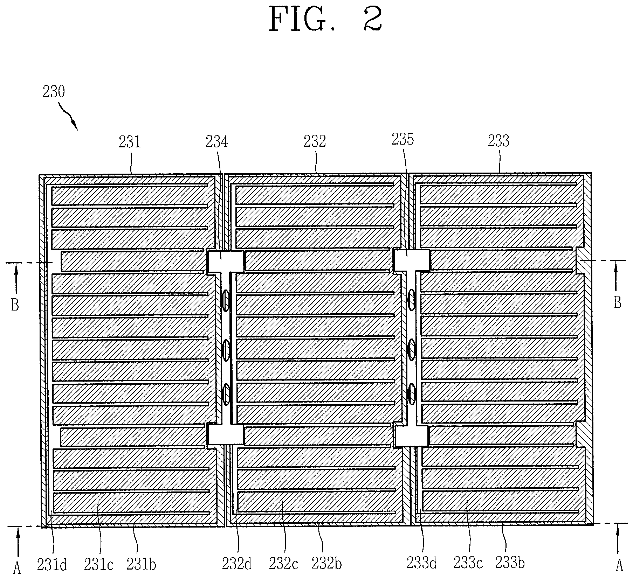

The solar cell module 130 includes strings 130a,130b, 130c connected to each other in parallel. Each of the strings 130a, 130b, 130c includes solar cells 131 connected to each other in series. Each of the solar cells 131 is connected and bonded to its neighboring solar cell 131 by interconnectors 234, 235 (refer to FIG. 2). A connecting and bonding structure by the interconnectors will be explained later.

The solar cell module 130 further includes a cover film 136 which covers both surfaces of the solar cells 131. The cover film 136 is formed of a polyethylene terephthalate (PET) material, and a thermoplastic resin is adhered to an outer surface of the PET material. The thermoplastic resin includes ethylene-vinyl acetate (EVA).

If a laminator having a high temperature of 100±10 °C is used after both surfaces of the solar cells 131 are covered by the cover film 136, the cover film 136 is thermally encapsulated on the both surfaces of the solar cells 131 by the thermoplastic resin.

A battery 140 is installed in the housing 110. The battery 140 is configured to store therein a power generated from the solar cell module 130. And the power stored in the battery 140 is supplied to an external device through a terminal 150.

The terminal 150 is exposed to the outside of the housing 110 so as to be connectable to the external device, and transmits the power provided from the battery 140 to the external device. For instance, the terminal 150 may be formed as a USB terminal 150, but the present invention is not limited to this. A converter 160 may be installed between the battery 140 and the terminal 150, and may be configured to perform an AC-DC conversion function and a voltage transformation function.

If the solar cell module 130 is withdrawn from the housing 110 by being unwound from the scroll bar 120 together with the screen 121 and is introduced into the housing 110 by being wound on the scroll bar 120, the portable charger 100 may maintain a relatively small size. The reason is because the solar cell module 130 can be withdrawn from the housing 110 at the time of using the solar cell module 130 for electricity generation, and the solar cell module 130 can be introduced into the housing 110 at the time of only carrying the portable charger 100.

Under such a configuration, the portable charger 100 having the solar cell module 130 can be minimized. However, in this case, the solar cell module 130 should have a flexibility so as to be wound on or unwound from the scroll bar 120.

Generally, the conventional solar cell formed of silicon has a size of 5 ∼6 inches, and has a brittleness. Thus, if the solar cell formed of silicon is repeatedly bent, it may be transformed or damaged without maintaining its mechanical strength. This may cause the solar cell formed of silicon not to have a flexibility.

Further, since the solar cell formed of silicon has a limited efficiency, it is inappropriate to apply the solar cell to the portable charger 100 having a limited size. The reason is because there is a limitation in an electricity generation capacity of the portable charger 100, if there is a limitation in efficiency of the solar cell, even if a light receiving area is obtained.

The solar cell module 130 is provided with a plurality of solar cells 131, and the solar cells 131 are connected to each other in parallel or in series. In order to minimize the portable charger 100 and to obtain a sufficient light receiving area, not only each of the solar cells 131, but also the solar cell module 130 formed as the solar cells 131 are assembled with each other should have a flexibility. Especially, if a connection structure for serially connecting two neighboring solar cells 131 to each other does not have a flexibility, the solar cell module 130 may not have a flexibility.

The present invention provides a configuration to solve such a problem, and the configuration will be explained in more detail with reference to the following drawings.

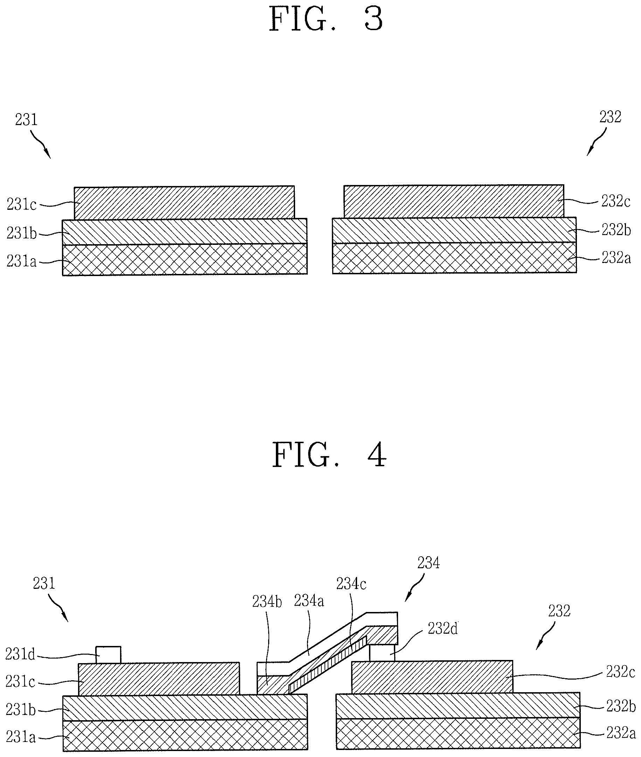

FIG. 2 is a planar view of a solar cell module 230 provided at a portable charger 200. FIG. 3 is a sectional view taken along line 'A-A' in the solar cell module 230 of FIG. 2, which is viewed from one side. And FIG. 4 is a sectional view taken along line 'B-B' in the solar cell module 230 of FIG. 2, which is viewed from one side.

The solar cell module 230 includes a plurality of solar cells 231, 232, 233, and interconnectors 234, 235 for serially connecting the solar cells 231, 232, 233 to each other. A structure of the solar cells 231, 232, 233 will be explained firstly, and then a structure of the interconnectors 234, 235 will be explained.

The solar cell module 230 is formed as the plurality of solar cells 231, 232, 233 are assembled with each other. If the plurality of solar cells 231, 232, 233 are connected to each other in series or in parallel to form an assembly (or a set), the solar cell module 230 is formed. FIG. 2 shows three solar cells 231, 232, 233 adjacent to each other. For convenience, the solar cells 231, 232, 233 may be sequentially referred to as the first solar cell 231, the second solar cell 232, and the third solar cell 233 from the left side.

Referring to FIGS. 3 and 4, the solar cells 231, 232 include flexible substrates 231a, 232a, lower electrodes 231b, 232b, III-V group compound semiconductors 231c, 232c and upper electrodes 231d, 232d.

The flexible substrates 231a, 232a are arranged at a lowermost side of the solar cells 231, 232. However, since the flexible substrates 231a, 232a are blocked by the lower electrodes 231b, 232b in the planar view, they are not shown in FIG. 2.

The flexible substrates 231a, 232a are formed to be bendable. The flexible substrates 231a, 232a may be formed as metal sheets, and the metal sheets may be formed of at least one of copper (Cu), aluminum (Al) and silver (Au). Alternatively, the flexible substrates 231a, 232a may be formed of synthetic resin or plastic, and the synthetic resin includes at least one of polyethylene phthalate (PET) and polyimide (PI).

Preferably, the flexible substrates 231a, 232a are formed to have a thickness of 50 ∼ 1,000 *µ*m. If the thickness of the flexible substrates 231a, 232a is smaller than 50 *µ*m, it is difficult to maintain a sufficient strength. On the other hand, if the thickness of the flexible substrates 231a, 232a is larger than 1,000 *µ*m, it is disadvantageous to implement a flexibility.

The lower electrodes 231b, 232b are formed on the flexible substrates 231a, 232a. The flexible substrates 231a, 232a and the lower electrodes 231b, 232b may be attached to each other by an ethylene-vinyl acetate copolymer (EVA), a silicon (Si)-based resin, or an acryl-based adhesive resin.

The III-V group compound semiconductors 231c, 232c are partially formed on the lower electrodes 231b, 232b such that partial regions of the lower electrodes 231b, 232b are exposed to the outside. Then, if the III-V group compound semiconductors 231c, 232c are partially etched through a mesa etching, the lower electrodes 231b, 232b are exposed to the outside. Such a structure is shown in FIG. 4.

The upper electrodes 231d, 232d are formed on the III-V group compound semiconductors 231c, 232c. The upper electrodes 231d, 232d may be displayed or may not be displayed according to a position of a sectional surface. For instance, the upper electrodes 231d, 232d are not displayed on the position 'A-A' of FIG. 2 as shown in FIG. 3. On the other hand, the upper electrodes 231d, 232d are displayed on the position 'B-B' of FIG. 2 as shown in FIG. 4.

The solar cells 231, 232 are electrically connected to each other by an electrical connection between the lower electrodes 231b, 232b and the upper electrodes 231d, 232d. As shown in FIG. 4, if the lower electrode 231b of the first solar cell 231 is electrically connected to the upper electrode 232d of the second solar cell 232 by the interconnector 234, the first and second solar cells 231, 232 are connected to each other in series.

The lower electrodes 231b, 232b and the upper electrodes 231d, 232d may have a thickness of 1 ∼15*µ*m. For bending of the solar cell module 230, the lower electrodes 231b, 232b and the upper electrodes 231d, 232d preferably have a small thickness. Therefore, it is preferable to limit the thickness of the lower electrodes 231b, 232b and the upper electrodes 231d, 232d to 15*µ*m to the maximum. If the thickness of the lower electrodes 231b, 232b and the upper electrodes 231d, 232d is smaller than 1 *µ*m, the lower electrodes 231b, 232b and the upper electrodes 231d, 232d may lose a durability due to their repeated bending.

The III-V group compound semiconductors 231c, 232c may be formed of GaAs unit thin films, and unit thin films such as GalnP, AllnP and AIGaAs may be added according to a required voltage. The III-V group compound semiconductors 231c, 232c are smaller and thinner than silicon semiconductors, and are less fragile than silicon. By such a characteristic, the solar cell module 230 may obtain a flexibility.

Since the III-V group compound semiconductors 231c, 232c are smaller than silicon semiconductors, the solar cells 231, 232 including the III-V group compound semiconductors 231c, 232c may be more bent than solar cells including silicon semiconductors.

The size of the solar cells 231, 232 is influenced by a semiconductor size. Accordingly, if the semiconductor size is small, the solar cells 231, 232 of a small size may be fabricated. Since the III-V group compound semiconductors 231c, 232c are smaller than silicon semiconductors, the solar cells 231, 232 of a relatively smaller size may be fabricated.

Since the solar cell module 230 is formed as the solar cells 231, 232 are assembled with each other, there is a boundary between the solar cells 231, 232. If the solar cells 231, 232 which constitute the solar cell module 230 have a small size, there are more boundaries within the same area.

When an external force is applied to the solar cell module 230, the solar cell module 230 is bent on the basis of the boundary. The fact that there are more boundaries within the same area means that there are more bendable positions. Accordingly, if there are more boundaries within the same area, the solar cell module 230 may be more bent.

The III-V group compound semiconductors 231c, 232c are thinner than silicon semiconductors. The III-V group compound semiconductors 231c, 232c may have a thickness of 1-4 *µ*m. On the other hand, the silicon semiconductors have a thickness of about 200 *µ*m. For the solar cell module 230 having a flexibility, the III-V group compound semiconductors 231c, 232c preferably have a small thickness. And the III-V group compound semiconductors 231c, 232c may have a sufficient photoelectric effect even at 4 *µ*m or less, and have a high efficiency. If the III-V group compound semiconductors 231c, 232c have a thickness smaller than 1 *µ*m, they may lose a durability as they are repeatedly bent.

The III-V group compound semiconductors 231c, 232c have higher efficiency and higher output than silicon semiconductors. Under the same condition, the solar cells 231, 232 including the III-V group compound semiconductors 231c, 232c have an efficiency of 27-31%. On the other hand, solar cells including silicon semiconductors have an efficiency of 16-23%. The number of solar cells which can be mounted to the portable charger 200 is limited. Accordingly, the unit solar cells 231, 232 should have a high efficiency such that an electricity generation capacity required by the portable charger 200 is satisfied.

Further, the III-V group compound semiconductors 231c, 232c are suitable for a portable device such as the portable charger 200, because they are lighter than silicon semiconductors.

Unlike the sectional surface shown in FIG. 3, the sectional surface shown in FIG. 4 illustrates the interconnector 234. The solar cell module 230 is formed by a set of the solar cells 231, 232, and the interconnector 234 is required to electrically connect the solar cells 231,232 with each other.

The interconnector 234 should be configured not only to electrically the solar cells with each other, but also to maintain a durability despite repetitive bending of the solar cell module 230, and to prevent a short circuit. The interconnector 234 is arranged at a boundary between the solar cells 231, 232, because the solar cell module 230 is bent on the basis of the boundary between the solar cells 231, 232.

A structure of the interconnector 234 will be explained with reference to FIGS. 2, 4, 5 and 6.

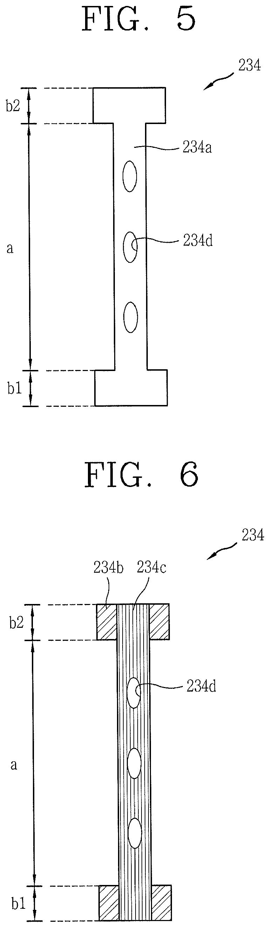

FIG. 5 is a planar view of the interconnector 234, and FIG. 6 is a bottom view of the interconnector 234.

The interconnector 234 is disposed at a boundary between the first and second solar cells 231,232 in order to serially connect the first and second solar cells 231, 232 with each other. Here, the first and second solar cells 231, 232 indicate any two solar cells adjacent to each other, not specific two solar cells of the solar cell module 230.

Referring to FIG. 4, the interconnector 234 is arranged to cover a region between the first and second solar cells 231, 232. And the interconnector 234 is electrically connected to the lower electrode 231b of the first solar cell 231 and the upper electrode 232d of the second solar cell 232. Thus, the first and second solar cells 231, 232 are serially connected to each other by the interconnector 234.

The interconnector 234 includes a base 234a, a conductive layer 234b, and an insulating layer 234c.

The base 234a is formed of a non-conductive material having elasticity. The non-conductive material having elasticity includes synthetic resin or plastic. In order to prevent occurrence of a short circuit due to bending of the solar cell module 230, the remaining region except for the conductive layer 234b to be explained later is preferably formed of a non-conductive material.

The base 234a may be extended along the boundary between the first and second solar cells 231, 232. Both ends of the base 234a are protruded towards the first and second solar cells 231, 232, and the conductive layer 234b for an electrical connection between the lower electrode and the upper electrode is disposed below the base 234a.

Preferably, the base 234a has a thickness of 10-200 *µ*m. If the thickness of the base 234a is smaller than 10 *µ*m, the solar cell module 230 may lose its durability as it is repeatedly bent at the boundary between the first and second solar cells 231, 232. On the other hand, if the thickness of the base 234a is larger than 200 *µ*m, it may be disadvantageous to implement a flexibility of the solar cell module 230.

The conductive layer 234b is formed on one surface of the base 234a. The one surface of the base 234a indicates a surface of the base 234a which faces the lower electrode 231b of the first solar cell 231 and the upper electrode 232d of the second solar cell 232.

The conductive layer 234b is electrically connected to the lower electrode 231b of the first solar cell 231 and the upper electrode 232d of the second solar cell 232. Accordingly, the first and second solar cells 231, 232 may be serially connected to each other, and may be electrically connected to each other.

The conductive layer 234b is protruded towards both sides of the insulating layer 234c to be explained later. Referring to FIG. 6, the base 234a is provided with protruded parts b1, b2 protruded to both sides towards the first and second solar cells 231, 232, and the conductive layer 234b is formed at the protruded parts b1, b2. Referring to FIG. 4, one side of the conductive layer 234b contacts the lower electrode 231b of the first solar cell 231, and another side thereof contacts the upper electrode 232d of the second solar cell 232.

Referring to FIG. 2, the protruded part b1 is protruded from one end of the base 234a to both sides towards the first and second solar cells 231, 232, and the protruded part b2 is protruded from another end of the base 234a towards the first and second solar cells 231, 232. Accordingly, the conductive layer 234b contacts the lower electrode 231b of the first solar cell 231 on at least two parts, and also contacts the upper electrode 232d of the second solar cell 232 on at least two parts.

The conductive layer 234b may be formed by coating a conductive material on the base 234a. The conductive layer 234b may be referred to as a conductive coating layer. The conductive coating layer may have a thickness of 1-100 *µ*m. If the thickness of the conductive coating layer is smaller than 1 *µ*m, an electrical connection may be interrupted. On the other hand, if the thickness of the conductive coating layer is larger than 100 *µ*m, it may be disadvantageous to implement a flexibility of the solar cell module 230.

The insulating layer 234c is formed on one surface of the conductive layer 234b in order to prevent a short circuit between the lower electrode 232b of the second solar cell 232 and the upper electrode 232d of the second solar cell 232. The one surface of the conductive layer 234b indicates a surface of the conductive layer 234b which faces the lower electrode 231b of the first solar cell 231 and the upper electrode 232d of the second solar cell 232. Referring to FIG. 6, the insulating layer 234c is extended along the boundary between the first and second solar cells 231, 232.

While the solar cell module 230 is repeatedly bent, the lower electrode 232b of the second solar cell 232 and the upper electrode 232d of the second solar cell 232 may contact each other. In this process, the lower electrode 232b of the second solar cell 232 and the upper electrode 232d of the second solar cell 232 may be electrically connected to each other to cause a short circuit. Alternatively, the short circuit may occur while the solar cells 231, 232 are bonded to each other.

If the insulating layer 234c is formed on one surface of the conductive layer 234b, a short circuit does not occur even if the lower electrode 232b of the second solar cell 232 and the upper electrode 232d of the second solar cell 232 contact the insulating layer 234c. It was explained that the insulating layer 234c prevents a short circuit between the lower electrode 232b of the second solar cell 232 and the upper electrode 232d of the second solar cell 232, with reference to FIG. 4. A short circuit may occur on any region of the solar cell module 230, and the insulating layer 234c prevents a short circuit between the lower electrodes 231b, 232b and the upper electrodes 231d, 232d of the solar cells 231, 232.

The insulating layer 234c may be formed in various manners, and may be provided with a different name according to a formation method of the insulating layer 234c.

For instance, the insulating layer 234c may be formed by coating an insulating material on the conductive layer 234b. In this case, the insulating layer 234c may be referred to as an insulating coating layer. As another example, the insulating layer 234c may be formed by attaching an insulating tape onto the conductive layer 234b. In this case, the insulating layer 234c may be referred to as an insulating adhesive layer. As another example, the insulating layer 234c may be formed by depositing a dielectric material between the first and second solar cells 231, 232. In this case, the insulating layer 234c may be referred to as a dielectric deposition layer.

After the insulating coating layer and the insulating adhesive layer are formed on the conductive layer 234b, the interconnector 234 is arranged to cover a space between the first and second solar cells 231, 232. Alternatively, after a dielectric deposition layer is formed at the space between the first and second solar cells 231, 232, the conductive layer 234b and the base 234a are disposed on the dielectric deposition layer. However, there is no difference therebetween in that the interconnector 234 includes the base 234a, the conductive layer 234b and the insulating layer 234c.

Referring to FIGS. 5 and 6, the interconnector 234 includes an extended part (a), a first protruded part (b1) and a second protruded part (b2).

Referring to FIG. 2, the extended part (a) is extended along a boundary between the first and second solar cells 231, 232.

The first protruded part (b1) is protruded from one end of the extended part (a) to both sides, towards the lower electrode 231b of the first solar cell 231 and the upper electrode 232d of the second solar cell 232. One side of the first protruded part (b1) contacts the lower electrode 231b of the first solar cell 231, and another side of the first protruded part (b1) contacts the upper electrode 232d of the second solar cell 232.

The second protruded part (b2) is protruded from another end of the extended part (a) to both sides, towards the lower electrode 231b of the first solar cell 231 and the upper electrode 232d of the second solar cell 232. One side of the second protruded part (b2) contacts the lower electrode 231b of the first solar cell 231, and another side of the second protruded part (b2) contacts the upper electrode 232d of the second solar cell 232.

The aforementioned conductive layer 234b is formed between the first protruded part (b1) and the second protruded part (b2). And the insulating layer 234c is formed at the extended part (a).

Referring to FIG. 2, the III-V group compound semiconductor 231c of the first solar cell 231, and the III-V group compound semiconductor 232c of the second solar cell 232 are recessed from positions of the first protruded part (b1) and the second protruded part (b2), in a direction that they become far from the first protruded part (b1) and the second protruded part (b2), respectively. Accordingly, the conductive layer 234b formed at the first protruded part (b1) and the second protruded part (b2) is spaced apart from the III-V group compound semiconductor 231c of the first solar cell 231 and the III-V group compound semiconductor 232c of the second solar cell 232.

One or more holes 234d for attenuating a stress generated when the solar cell module 230 is bent are formed at the extended part (a). The holes 234d are spaced apart from each other, and may have a circular shape, an oval shape or a polygonal shape.

When compared with a structure that the extended part (a) is not provided with the hole 234d, the structure that the extended part (a) is provided with the hole 234d has a larger endurance against an accumulated stress. The reason is because a stress may be continuously released through the hole 234d.

Although not shown, the solar cell module 230 may further include a passivation film (not shown) for covering the solar cells and the interconnectors 234. The passivation film may be formed of a synthetic resin-based material in order to prevent an introduction of moisture or a contamination, and may be formed to hermetically cover the solar cell module 230.

FIG. 4 shows that the solar cell module 230 has a height difference according to its region by the interconnector 234. However, since each layer substantially has a very small thickness of *µ*m, a user cannot recognize a height difference with naked eyes. In this case, the user may recognize the solar cell module 230 as a plane.

The aforementioned solar cell module and the portable charger having the same are not limited to the configuration and the method of the aforementioned embodiments. The embodiments may be selectively combined with each other partially or wholly for various modifications.

In the present invention, since the solar cells include the III-V group compound semiconductors, the small and thin solar cell module having a flexibility may be implemented. Further, the interconnector for electrically connecting the two solar cells adjacent to each other is disposed between the two solar cells. The interconnector is configured not only to electrically the solar cells with each other, but also to maintain a durability despite repetitive bending of the solar cell module. Accordingly, the solar cell module having a flexibility may be implemented.

If the solar cell module has its flexibility by the III-V group compound semiconductors and the interconnectors, it does not lose its durability even when bent. This may allow a portability of a portable device to be obtained, and allow the solar cell module to have a high output.

Further, in the present invention, the insulating layer of the interconnector is configured to prevent a short circuit generated in the solar cell module. This may allow a reliability of the interconnector to be maintained even when the solar cell module is repeatedly bent.

## Claims

1. A solar cell module (130, 230), comprising:
a first solar cell (231) and a second solar cell (232) disposed to be adjacent to each other, each of the first solar cell (231) and the second solar cell (232) including:
a flexible substrate (231a, 232a);
a lower electrode (231b, 232b) formed on the flexible substrate (231a, 232a);
a III-V group compound semiconductor (231c, 232c) formed on a part of the lower electrode (231b, 232b) such that a portion of the lower electrode (231b, 232b) is exposed; and
an upper electrode (231d, 232d) formed on the III-V group compound semiconductor (231c, 232c); and
an interconnector (234) disposed to cover a space between the first and second solar cells (231, 232), and configured to electrically connect the lower electrode (231b) of the first solar cell (231) and the upper electrode (232d) of the second solar cell (232),
wherein the interconnector (234) includes:
a non-conducting and elastic base (234a);
a conductive layer (234b) disposed on one surface of the base (234a), the conductive layer (234b) being electrically connected to the lower electrode (231b) of the first solar cell (231) and the upper electrode (232d) of the second solar cell (232); and
an insulating layer (234c) disposed on the conductive layer (234b),
wherein the conductive layer (234b) extends on both sides of the insulating layer (234c), and
wherein one side of the conductive layer (234b) contacts the lower electrode (231b) of the first solar cell (231), and another side of the conductive layer (234b) contacts the upper electrode (232d) of the second solar cell (232).

2. The solar cell module (130, 230) of claim 1, wherein the conductive layer (234b) includes a conductive material coated on the one surface of the base (234a).

3. The solar cell module (130, 230) of claim 1 or 2, wherein the insulating layer (234c) includes an insulating coating disposed on the conductive layer (234b).

4. The solar cell module (130, 230) of claim 1 or 2, wherein the insulating layer (234c) includes an insulating adhesive attached to the conductive layer (234b).

5. The solar cell module (130, 230) of claim 1 or 2, wherein the insulating layer (234c) includes a dielectric deposition layer deposited between the first solar cell (231) and the second solar cell (232).

6. The solar cell module (130, 230) of any one of claims 2 to 5, wherein
the base (234a) has a thickness of 10 µm to 200 µm, and
the conductive coating layer has a thickness of 1 µm to 100 µm.

7. The solar cell module (130, 230) of any one preceding claim, wherein the interconnector (234) includes:
an extended part (a) disposed along a boundary between the first solar cell (231) and the second solar cell (232);
a first protruded part (b1) disposed at one end of the extended part (a), the first protruded part (b1) extending from both sides of the extended part (a); and
a second protruded part (b2) disposed at an opposite end of the extended part (a), the second protruded part (b2) extending from the both sides of the extended part (a).

8. The solar cell module (130, 230) of claim 7, wherein
the conductive layer (234b) is disposed on the first and second protruded parts (b1, b2), and
the insulating layer (234c) is disposed on the extended part (a).

9. The solar cell module (130, 230) of claim 7 or 8, wherein
a portion of the first protruded part (b1) disposed on one side of the extended part (a) and a portion of the second protruded part (b2) disposed on the one side of the extended part (a) contact the lower electrode (231b) of the first solar cell (231), and
another portion of the first protruded part (b1) disposed on an opposite side of the extended part (a) and another portion of the second protruded part (b2) disposed on the opposite side of the extended part (a) contact the upper electrode (232d) of the second solar cell (232).

10. The solar cell module (130, 230) of any one of claims 7 to 9, wherein the extended part (a) includes at least one hole (234d).

11. The solar cell module (130, 230) of claim 10, wherein the at least one hole (234d) includes a plurality of holes (234d) spaced apart from each other.

12. The solar cell module (130, 230) of any one preceding claim, further comprising a passivation film configured to cover the solar cells and the interconnector (234).

13. The solar cell module (130, 230) of any one preceding claim, wherein
the flexible substrate (231a, 232a) has a thickness of 50 µm to 1,000 µm,
each of the upper and lower electrodes (231d, 232d, 231b, 232b) has a thickness of 1 µm to 15 µm, and
the III-V group compound semiconductor (231c, 232c) has a thickness of 1 µm to 4 µm.

## Patentansprüche

1. Solarzellenmodul (130, 230) umfassend:
eine erste Solarzelle (231) und eine zweite Solarzelle (232), die so angeordnet sind, dass sie nebeneinanderliegen, wobei jede der ersten Solarzellen (231) und der zweiten Solarzelle (232) umfasst:
ein flexibles Substrat (231a, 232a);
eine untere Elektrode (231b, 232b), die auf dem flexiblen Substrat (231a, 232a) ausgebildet ist;
einen Verbindungshalbleiter der III-V-Gruppe (231c, 232c), der auf einem Teil der unteren Elektrode (231b, 232b) so ausgebildet ist, dass ein Abschnitt der unteren Elektrode (231b, 232b) freigelegt ist; und
eine obere Elektrode (231d, 232d), die auf dem Verbindungshalbleiter der III-V-Gruppe (231c, 232c) ausgebildet ist; und
einen Interkonnektor (234), der angeordnet ist, um einen Raum zwischen der ersten und der zweiten Solarzelle (231, 232) abzudecken, und eingerichtet ist, um die untere Elektrode (231b) der ersten Solarzelle (231) und die obere Elektrode (232d) der zweiten Solarzelle (232) elektrisch zu verbinden,
wobei der Interkonnektor (234) umfasst:
eine nichtleitende und elastische Basis (234a);
eine leitende Schicht (234b), die auf einer Oberfläche der Basis (234a) angeordnet ist, wobei die leitende Schicht (234b) mit der unteren Elektrode (231b) der ersten Solarzelle (231) und der oberen Elektrode (232d) der zweiten Solarzelle (232) elektrisch verbunden ist; und
eine Isolierschicht (234c), die auf der leitenden Schicht (234b) angeordnet ist,
wobei sich die leitende Schicht (234b) auf beiden Seiten der Isolierschicht (234c) erstreckt und
wobei eine Seite der leitenden Schicht (234b) die untere Elektrode (231b) der ersten Solarzelle (231) berührt und eine andere Seite der leitenden Schicht (234b) die obere Elektrode (232d) der zweiten Solarzelle (232) berührt.

2. Solarzellenmodul (130, 230) nach Anspruch 1, wobei die leitende Schicht (234b) ein leitendes Material enthält, das auf der einen Oberfläche der Basis (234a) aufgetragen ist.

3. Solarzellenmodul (130, 230) nach Anspruch 1 oder 2, wobei die Isolierschicht (234c) eine Isolierbeschichtung enthält, die auf der leitenden Schicht (234b) angeordnet ist.

4. Solarzellenmodul (130, 230) nach Anspruch 1 oder 2, wobei die Isolierschicht (234c) ein Isolierhaftmittel enthält, das auf der leitenden Schicht (234b) angebracht ist.

5. Solarzellenmodul (130, 230) nach Anspruch 1 oder 2, wobei die Isolierschicht (234c) eine dielektrische Abscheidungsschicht enthält, die zwischen der ersten Solarzelle (231) und der zweiten Solarzelle (232) abgeschieden ist.

6. Solarzellenmodul (130, 230) nach einem der Ansprüche 2 bis 5, wobei
die Basis (234a) eine Dicke von 10 µm bis 200 µm hat und
die leitende Überzugsschicht eine Dicke von 1 µm bis 100 µm hat.

7. Solarzellenmodul (130, 230) nach einem der vorhergehenden Ansprüche, wobei der Interkonnektor (234) umfasst:
einen verlängerten Teil (a), der entlang einer Grenze zwischen der ersten Solarzelle (231) und der zweiten Solarzelle (232) angeordnet ist;
einen ersten hervorstehenden Teil (b1), der an einem Ende des verlängerten Teils (a) angeordnet ist, wobei sich der erste hervorstehende Teil (b1) von beiden Seiten des verlängerten Teils (a) erstreckt; und
einen zweiten hervorstehenden Teil (b2), der an einem gegenüberliegenden Ende des verlängerten Teils (a) angeordnet ist, wobei sich der zweite hervorstehende Teil (b2) von den beiden Seiten des verlängerten Teils (a) erstreckt.

8. Solarzellenmodul (130, 230) nach Anspruch 7, wobei
die leitende Schicht (234b) auf dem ersten und dem zweiten hervorstehenden Teil (b1, b2) angeordnet ist und
die Isolierschicht (234c) auf dem verlängerten Teil (a) angeordnet ist.

9. Solarzellenmodul (130, 230) nach Anspruch 7 oder 8, wobei
ein Abschnitt des ersten hervorstehenden Teils (b1), der auf einer Seite des verlängerten Teils (a) angeordnet ist, und ein Abschnitt des zweiten hervorstehenden Teils (b2), der auf der einen Seite des verlängerten Teils (a) angeordnet ist, die untere Elektrode (231b) der ersten Solarzelle (231) berührt und
ein anderer Abschnitt des ersten hervorstehenden Teils (b1), der auf einer gegenüberliegenden Seite des verlängerten Teils (a) angeordnet ist, und ein anderer Abschnitt des zweiten hervorstehenden Teils (b2), der auf der gegenüberliegenden Seite des verlängerten Teils (a) angeordnet ist, die obere Elektrode (232d) der zweiten Solarzelle (232) berührt.

10. Solarzellenmodul (130, 230) nach einem der Ansprüche 7 bis 9, wobei der verlängerte Teil (a) mindestens ein Loch (234d) enthält.

11. Solarzellenmodul (130, 230) nach Anspruch 10, wobei das mindestens eine Loch (234d) eine Mehrzahl von Löchern (234d) enthält, die voneinander beabstandet sind.

12. Solarzellenmodul (130, 230) nach einem der vorhergehenden Ansprüche, ferner umfassend einen Passivierungsfilm, der eingerichtet ist, um die Solarzellen und den Interkonnektor (234) abzudecken.

13. Solarzellenmodul (130, 230) nach einem der vorhergehenden Ansprüche, wobei
das flexible Substrat (231a, 232a) eine Dicke von 50 µm bis 1000 µm hat, wobei jede der oberen und unteren Elektroden (231d, 232d, 231b, 232b) eine Dicke von 1 µm bis 15 µm hat, und
der Verbindungshalbleiter der III-V-Gruppe (231c, 232c) eine Dicke von 1 µm bis 4 µm hat.

## Revendications

1. Module de cellule solaire (130, 230), comprenant :
une première cellule solaire (231) et une seconde cellule solaire (232) disposées pour être adjacentes l'une à l'autre, chacune de la première cellule solaire (231) et de la seconde cellule solaire (232) comprenant :
un substrat flexible (231a, 232a) ;
une électrode inférieure (231b, 232b) formée sur le substrat flexible (231a, 232a) ;
un semi-conducteur à composé du groupe III-V (231c, 232c) formé sur une partie de l'électrode inférieure (231b, 232b) de telle sorte qu'une partie de l'électrode inférieure (231b, 232b) est exposée ; et
une électrode supérieure (231d, 232d) formée sur le semi-conducteur à composé du groupe III-V (231c, 232c) ; et
un interconnecteur (234) disposé pour couvrir un espace entre les première et seconde cellules solaires (231, 232), et conçu pour connecter électriquement l'électrode inférieure (231b) de la première cellule solaire (231) et l'électrode supérieure (232d) de la seconde cellule solaire (232),
dans lequel l'interconnecteur (234) comprend :
une base non conductrice et élastique (234a) ;
une couche conductrice (234b) disposée sur une surface de la base (234a), la couche conductrice (234b) étant électriquement connectée à l'électrode inférieure (231b) de la première cellule solaire (231) et à l'électrode supérieure (232d) de la seconde cellule solaire (232) ; et
une couche isolante (234c) disposée sur la couche conductrice (234b),
dans lequel la couche conductrice (234b) s'étend des deux côtés de la couche isolante (234c), et
dans lequel un côté de la couche conductrice (234b) est en contact avec l'électrode inférieure (231b) de la première cellule solaire (231), et un autre côté de la couche conductrice (234b) est en contact avec l'électrode supérieure (232d) de la seconde cellule solaire (232).

2. Module de cellule solaire (130, 230) selon la revendication 1, dans lequel la couche conductrice (234b) comprend un matériau conducteur appliqué sur la première surface de la base (234a).

3. Module de cellule solaire (130, 230) selon la revendication 1 ou 2, dans lequel la couche isolante (234c) comprend un revêtement isolant disposé sur la couche conductrice (234b).

4. Module de cellule solaire (130, 230) selon la revendication 1 ou 2, dans lequel la couche isolante (234c) comprend un adhésif isolant fixé à la couche conductrice (234b).

5. Module de cellule solaire (130, 230) selon la revendication 1 ou 2, dans lequel la couche isolante (234c) comprend une couche de dépôt diélectrique déposée entre la première cellule solaire (231) et la seconde cellule solaire (232).

6. Module de cellule solaire (130, 230) selon l'une quelconque des revendications 2 à 5, dans lequel
la base (234a) a une épaisseur de 10 µm à 200 µm, et
la couche de revêtement conducteur a une épaisseur de 1 µm à 100 µm.

7. Module de cellule solaire (130, 230) selon l'une quelconque des revendications précédentes, dans lequel l'interconnecteur (234) comprend :
une partie étendue (a) disposée le long d'une limite entre la première cellule solaire (231) et la seconde cellule solaire (232) ;
une première partie en saillie (b1) disposée à une extrémité de la partie étendue (a), la première partie en saillie (b1) s'étendant des deux côtés de la partie étendue (a) ; et
une seconde partie en saillie (b2) disposée à une extrémité opposée de la partie étendue (a), la seconde partie en saillie (b2) s'étendant des deux côtés de la partie étendue (a).

8. Module de cellule solaire (130, 230) selon la revendication 7, dans lequel
la couche conductrice (234b) est disposée sur les première et seconde parties en saillie (b1, b2), et
la couche isolante (234c) est disposée sur la partie étendue (a).

9. Module de cellule solaire (130, 230) selon la revendication 7 ou 8, dans lequel
une partie de la première partie en saillie (b1) disposée sur un côté de la partie étendue (a) et une partie de la seconde partie en saillie (b2) disposée sur ledit côté de la partie étendue (a) sont en contact avec l'électrode inférieure (231b) de la première cellule solaire (231), et
une autre partie de la première partie en saillie (b1) disposée sur un côté opposé de la partie étendue (a) et une autre partie de la seconde partie en saillie (b2) disposée sur le côté opposé de la partie étendue (a) sont en contact avec l'électrode supérieure (232d) de la seconde cellule solaire (232).

10. Module de cellule solaire (130, 230) selon l'une quelconque des revendications 7 à 9, dans lequel la partie étendue (a) comprend au moins un trou (234d).

11. Module de cellule solaire (130, 230) selon la revendication 10, dans lequel l'au moins un trou (234d) comprend une pluralité de trous (234d) espacés les uns des autres.

12. Module de cellule solaire (130, 230) selon l'une quelconque des revendications précédentes, comprenant en outre un film de passivation conçu pour recouvrir les cellules solaires et l'interconnecteur (234).

13. Module de cellule solaire (130, 230) selon l'une quelconque des revendications précédentes, dans lequel
le substrat flexible (231a, 232a) a une épaisseur de 50 µm à 1 000 µm,
chacune des électrodes supérieure et inférieure (231d, 232d, 231b, 232b) a une épaisseur de 1 µm à 15 µm, et
le semi-conducteur à composé du groupe III-V (231c, 232c) a une épaisseur de 1 µm à 4 µm.
